**Europäisches Patentamt**

**European Patent Office**

**Office européen des brevets**

(19)

(11) Veröffentlichungsnummer: **0 167 478
B1**

(12)

# EUROPÄISCHE PATENTSCHRIFT

(45) Veröffentlichungstag der Patentschrift:
**14.09.88**

(51) Int. Cl.⁴: **H 05 K 7/14**

(21) Anmeldenummer: **85730077.6**

(22) Anmeldetag: **05.06.85**

(54) **Einzelgehäuse für eine modular aufbaubare Gehäuseordnung.**

(30) Priorität: **07.06.84 DE 3421551**

(43) Veröffentlichungstag der Anmeldung:
**08.01.86 Patentblatt 86/2**

(45) Bekanntmachung des Hinweises auf die Patenterteilung:
**14.09.88 Patentblatt 88/37**

(84) Benannte Vertragsstaaten:
**AT BE CH DE LI NL SE**

(56) Entgegenhaltungen:
**CH - A - 400 288
FR - A - 2 312 917
FR - A - 2 486 757**

(73) Patentinhaber: **Siemens Aktiengesellschaft Berlin und München, Wittelsbacherplatz 2, D-8000 München 2 (DE)**

(72) Erfinder: **Fahrenkrog-Petersen, Dieter, Radelandstrasse 104a, D-1000 Berlin 20 (DE)**

## Beschreibung

Die Erfindung bezieht sich auf ein Einzelgehäuse für eine modular aufbaubare Gahäuseanordnung, bei der die Einzelgehäuse jeweils eine solche Breite aufweisen, dass durch Nebeneinanderanordnen mehrerer Einzelgehäuse jeweils eine vorgegebene Breite erzielbar ist.

Bekannte Einzelgehäuse für eine modular aufgebaute Gehäuseanordnung (Publikation R-6020 «GEC Measurements MiDOS» der General Electric Company p.l.c. of England) bestehen aus einem einzigen Blechband, das mehrfach rechtwinklig abgebogen ist und an seinen gegeneinanderstossenden Enden mittels eines untergelegten Verbindungsstreifens durch Nieten verbunden ist; an der Vorderseite der bekannten Einzelgehäuse sind Deckel angeschraubt. Vor der Befestigung des Deckels ist in die bekannten Einzelgehäuse ein fertigmontierter Einschub einbringbar, der an seiner Rückseite eine Kontaktanordnung aufweist, die zur Bildung der Rückseite des Einzelgehäuses beiträgt. Die bekannten Einzelgehäuse sind zur Aufnahme von Schutzrelais vorgesehen und entsprechend dem benötigten Platzbedarf bei gleicher Höhe der Einzelgehäuse unterschiedlich breit ausgebildet; es stehen sechs Einzelgehäuse unterschiedlicher Breite zur Verfügung, um die verschiedenen Relais unterbringen und dabei insgesamt eine modular aufgebaute Gehäuseanordnung vorgegebener Breite erzielen zu können.

Der Erfindung liegt die Aufgabe zugrunde, Einzelgehäuse für eine modular aufbaubare Gehäuseanordnung anzugeben, die sich mit verhältnismässig geringem Aufwand herstellen lassen.

Zur Lösung dieser Aufgabe besteht erfindungsgemäss jedes Einzelgehäuse aus zwei Gehäuseteilen, und die Gehäuseteile weisen entweder jeweils eine Breite von $1/_{12}$ oder von $3/_{12}$ der vorgegebenen Breite auf.

Ein wesentlicher Vorteil des erfindungsgemässen Einzelgehäuses besteht darin, dass mit nur zwei Gehäuseteilen der angegebenen Breite, die ansonsten identisch sind, drei unterschiedlich breite Einzelgehäuse herstellbar sind, wobei die unterschiedlichen Einzelgehäuse $1/_6$, $1/_3$ und $1/_2$ der vorgegebenen Breite der modular aufgebauten Gehäuseanordnung ausmachen. Dadurch wird der Herstellungsaufwand vermindert und die Lagerhaltung vereinfacht.

Bei dem erfindungsgemässen Einzelgehäuse können die beiden Gehäuseteile in unterschiedlicher Weise miteinander verbunden werden. Im Hinblick darauf, dass die Wandungen der beiden Gehäuseteile zur Verringerung des Materialaufwandes und zur Gewichtsersparnis verhältnismässig dünn ausgebildet sind, erscheint ein Verkleben der Gehäuseteile wegen der geforderten Festigkeit nicht zweckmässig. Als vorteilhaft wird es daher angesehen, dass jedes Gehäuseteil bei der Zusammenführung zu einem Einzelgehäuse in seiner oberen und unteren Verbindungsfläche eine Nut aufweist, in die ein Verbindungsstreifen einbringbar ist. Dieser Verbindungsstreifen ist in seiner Stärke der Breite der Nut entsprechend beschaffen und wird beim Zusammenfügen der beiden Gehäuseteile unter Krafteinwirkung in die einander gegenüberliegenden Nuten beider Gehäuseteile eingepresst, wodurch auf herstellungstechnisch einfache Weise eine dichte und feste Verbindung der beiden Gehäuseteile miteinander geschaffen ist.

Bei dem erfindungsgemässen Einzelgehäuse sind die Gehäuseteile vorteilhafterweise Kunststoff-Spritzteile, und der Verbindungsstreifen besteht aus einem verhältnismässig weichen Metall mit leichter Riffelung; dabei ist insbesondere an Aluminium gedacht. Die leichte Riffelung des Verbindungsstreifens bewirkt, dass dieser sich beim Zusammenfügen der beiden Gehäuseteile gewissermassen in die Seitenwände der Nut eingräbt und festhakt, wodurch eine besonders feste Verbindung der beiden Gehäuseteile erreicht ist.

Soll ein Einzelgehäuse mit einem besonders stabilen und robusten Aufbau erzielt werden, dann kann es vorteilhaft sein, die Gehäuseteile als Metall-Spritzteile auszuführen und als Verbindungsstreifen einen Streifen aus Kunststoff zu verwenden.

Um im Falle eines Einzelgehäuses für Geräte der elektrischen Schutztechnik dieses Einzelgehäuse in einfacher Weise an einer Schalttafelwand anbringen zu können, weist jedes Gehäuseteil vorteilhafterweise an seiner Vorderseite einen sich jeweils bis zu den Verbindungsflächen erstreckenden Kragen auf, der an seinem einen Ende eine Ausnehmung und an seinem anderen Ende einen Verbindungsansatz aufweist. Der Verbindungsansatz ist jeweils symmetrisch zur Ausnehmung im Kragen angebracht, so dass beim Zusammenfügen zweier solchermassen ausgebildeter Gehäuseteile eine Schnappverbindung geschaffen ist, die den Zusammenhalt der beiden Gehäuseteile zu einem Einzelgehäuse festigt.

Als vorteilhaft hat es sich ferner erwiesen, wenn jedes Gehäuseteil an seiner Rückseite eine Nut zur Aufnahme einer Rückwand aufweist, jedes Gehäuseteil an seiner Rückseite einen Befestigungslappen trägt und die Rückwand mit dem Befestigungslappen verbunden ist. Dabei muss sich die Rückwand nicht über die ganze Höhe des Einzelgehäuses erstrecken, sondern kann sich gegebenenfalls nur zwischen einander gegenüberliegenden Befestigungslappen beider Gehäuseteile eines Einzelgehäuses erstrecken, weil dadurch die Festigkeit der Verbindung der beiden Gehäuseteile im Bereich der Rückseite des Einzelgehäuses verstärkt wird. Die freien Bereiche auf der Rückseite des Einzelgehäuses können dann dazu benutzt werden, Anschlussklemm-Vorrichtungen aufzunehmen. Zur Erläuterung der Erfindung ist in der

Fig. 1 der mit dem erfindungsgemässen Einzelgehäuse erzielbare modulare Aufbau einer Gehäuseanordnung schematisch dargestellt und in

Fig. 2 in perspektivischer Darstellung ein Ausführungsbeispiel des erfindungsgemässen Einzelgehäuses in seinen wesentlichen Teilen wiedergegeben.

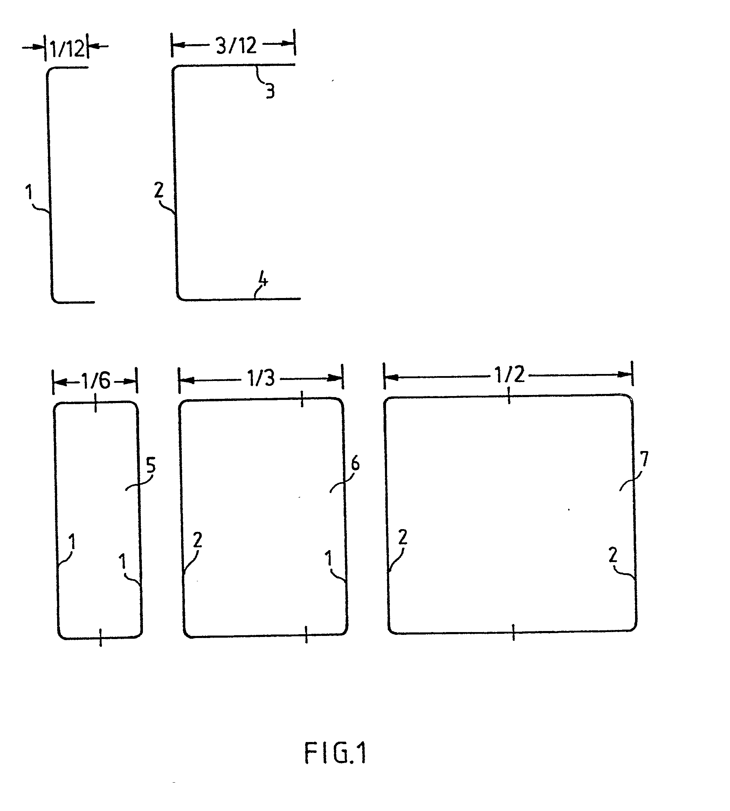

Wie die Figur 1 erkennen lässt, hat ein in der Seitenansicht im wesentlichen U-förmig ausgebildetes erstes Gehäuseteil 1 eine Breite von $1/_{12}$ der vorgegebenen Breite einer nicht dargestellten modular aufgebauten Gehäuseanordnung. Ein zweites Gehäuseteil 2 ist in der Seitenansicht ebenfalls U-förmig ausgebildet und unterscheidet sich vom ersten Gehäuseteil 1 im wesentlichen nur durch längere Schenkel 3 und 4. Dabei ist das zweite Gehäuseteil 2 so ausgeführt, dass es eine Breite von $3/_{12}$ der vorgegebenen Breite der modular aufgebauten Gehäuseanordnung aufweist.

Wie die Darstellung nach Figur 1 weiterhin zeigt, lässt sich durch Aneinanderfügen zweier Gehäuseteile 1 ein Einzelgehäuse 5 gewinnen, dessen Breite der doppelten Breite des ersten Gehäuseteiles 1 entspricht, und das somit eine Gesamtbreite von $1/_6$ der vorgegebenen Breite der modular aufgebauten Gehäuseanordnung besitzt. Ein weiteres Einzelgehäuse 6 mit einer Breite von $1/_3$ der vorgegebenen Breite der Gehäuseanordnung ergibt sich dadurch, dass ein erstes Gehäuseteil 1 mit einem zweiten Gehäuseteil 2 verbunden wird, wie ebenfalls aus der Figur 1 ersichtlich ist. Ein zusätzliches Einzelgehäuse 7 mit einer der Hälfte der vorgegebenen Breite der modular aufgebauten Gehäuseanordnung entsprechenden Breite ergibt sich durch Zusammenfügen aus zwei Gehäuseteilen 2. Allein aus den beiden Gehäuseteilen 1 und 2 lassen sich daher drei unterschiedlich breite Gehäuseteile gewinnen.

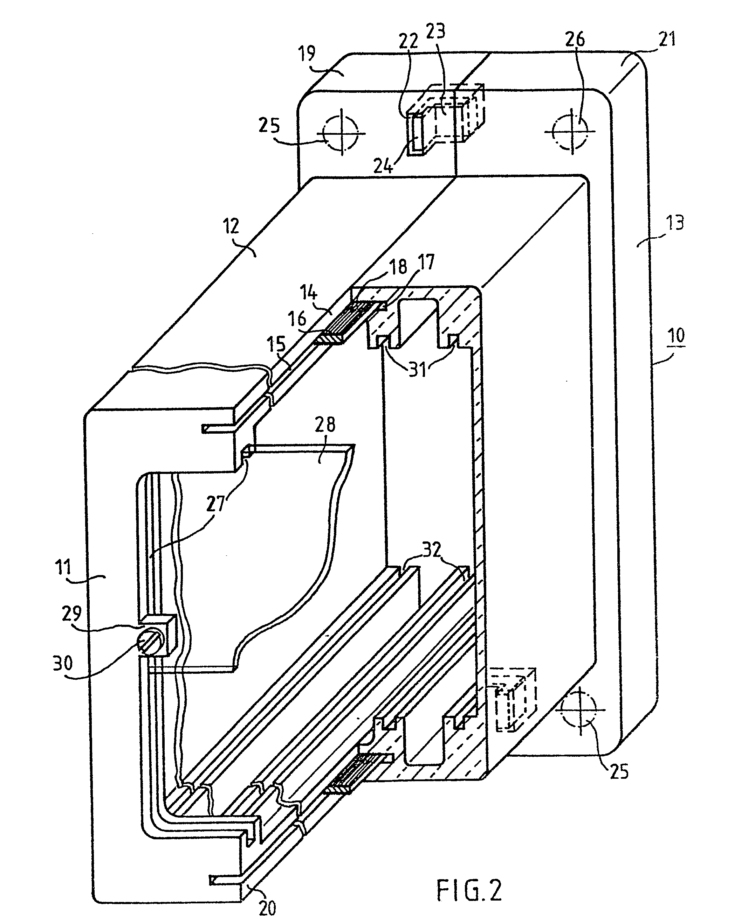

In Figur 2 ist ein Einzelgehäuse 10 in perspektivischer Darstellung mit einem Blick auf die Rückseite 11 wiedergegeben. Das Einzelgehäuse 10 besteht aus einem Gehäuseteil 12 und einem weiteren Gehäuseteil 13, die jeweils eine gleiche Breite aufweisen und somit entweder dem Gehäuseteil 1 nach Figur 1 oder dem Gehäuseteil 2 nach derselben Figur entsprechen. Das Gehäuseteil 12 weist in einer Verbindungsfläche 14 eine Nut 15 auf, in die ein Verbindungsstreifen 16 eingebracht ist. Dieser Verbindungsstreifen 16 greift nicht nur in die Nut 15 des Gehäuseteils 12, sondern auch in eine Nut 17 des Gehäuseteils 13 ein und schafft somit über einen weiten Bereich der Verbindungsfläche 14 des Einzelgehäuses 10 eine dichte und mechanisch feste Verbindung der beiden Gehäuseteile 12 und 13. Dies ist darauf zurückzuführen, dass der Verbindungsstreifen 16 vor dem Zusammenfügen der beiden Gehäuseteile 12 und 13 zunächst nur mit seinen Randbereichen in die einander gegenüberliegenden Nuten 15 und 17 der Gehäuseteile 12 und 13 eingeführt ist und sich danach beim Zusammendrücken der beiden Gehäuseteile in die Nuten 15 und 17 einpresst, wobei durch eine schwache Riffelung 18 im mittleren Bereich des Streifens 16 ein Eingraben bzw. Verhaken des Verbindungsstreifens in den Seitenwänden der Nuten 15 und 17 eintritt. Um dies zu erreichen, ist bei aus Kunststoff hergestellten Gehäuseteilen 12 und 13 der Verbindungsstreifen vorzugsweise aus Aluminium hergestellt.

Wie die Figur 2 ferner erkennen lässt, weist das Gehäuseteil 12 einen Kragen 19 auf, der sich von der oberen Verbindungsfläche 14 bis zur unteren Verbindungsfläche 20 erstreckt; entsprechend verläuft ein Kragen 21 des Gehäuseteils 13. Im Bereich der Verbindungsfläche 14 ist der Kragen 19 mit einer Ausnehmung 22 versehen, in der ein Verbindungsansatz 23 am oberen Ende des Kragens 21 des anderen Gehäuseteils 13 mit einem Haken 24 federnd eingreift, so dass zusätzlich zu der Verbindung der beiden Gehäuseteile 12 und 13 mittels des Verbindungsstreifens 16 eine kraft- und formschlüssige Verbindung dieser beiden Gehäuseteile im Bereich der relativ dickwandigen Kragen 19 und 21 erreicht ist. Am jeweils anderen Ende der Kragen 19 bzw. 21 sind – in der Figur 2 nicht erkennbar – die Ausnehmung und der Verbindungsansatz vertauscht, d.h. es trägt der Kragen 19 an seinem unteren Ende einen Verbindungsansatz und der Kragen 21 weist an seinem unteren Ende eine Ausnehmung auf, so dass auch dort eine form- und kraftschlüssige Schnappverbindung der beiden Gehäuseteile erreicht ist.

Jeder Kragen 19 bzw. 21 ist mit jeweils einer Bohrung 25 versehen, mit der eine Befestigung des Einzelgehäuses 10 an einer nicht dargestellten Wand, beispielsweise einer Schalttafel, erfolgen kann. Weitere Bohrungen 26 in den Kragen 19 und 20 dienen zur Halterung eines in der Figur nicht dargestellten Deckels.

Wie die Figur 2 ferner zeigt, ist das Gahäuseteil 12 an der Rückseite 11 des Einzelgehäuses mit einer Nut 27 versehen, der eine entsprechend bemessene, in der Figur nicht erkennbare Nut im anderen Gehäuseteil 13 gegenüberliegt. In die Nut 27 ist eine Rückwand 28 beim Zusammenfügen der beiden Gehäuseteile 12 und 13 eingefügt. Diese Rückwand 28 erstreckt sich bei dem dargestellten Ausführungsbeispiel nicht über die gesamte Höhe des Einzelgehäuses 10, weil der untere Bereich zur Aufnahme einer nicht dargestellten Kontakteinrichtung freigelassen ist. An der Rückseite trägt das Gehäuseteil 12 ausserdem einen Befestigungslappen 29, an den mittels einer Schraube 30 die Rückwand 28 befestigt ist. Da das andere Gehäuseteil 13 eine entsprechende Ausgestaltung aufweist, wird über die Rückwand eine feste Verbindung der beiden Gehäuseteile 12 und 13 auch im Bereich der Rückseite 11 gewährleistet.

Das erfindungsgemässe Einzelgehäuse ist vor allem zur Aufnahme von gedruckten Schaltungsplatten geeignet und weist daher jeweils oben und unten in die Tiefe verlaufende Nuten 31 bzw. 32 auf, in die nicht dargestellte Schaltungsplatten einführbar sind. Die Schaltungsplatten tragen an ihrer Rückseite die ebenfalls nicht dargestellte Kontaktanordnung in einer solchen Weise, dass im Zusammenwirken mit der Rückwand 28 und den übrigen Seitenwänden eine Abdichtung des Innenraumes des Einzelgehäuses 10 nach aussen eintritt.

## Patentansprüche

1. Einzelgehäuse für eine modular aufbaubare Gehäuseanordnung, bei der die Einzelgehäuse jeweils eine solche Breite aufweisen, dass durch Nebeneinanderanordnen mehrerer Einzelgehäuse jeweils eine vorgegebene Breite erzielbar ist, dadurch gekennzeichnet, dass jedes Einzelgehäuse (10) aus zwei Gehäuseteilen (12, 13) besteht und dass die Gehäuseteile (12, 13) entweder jeweils eine Breite von $^1/_{12}$ oder von $^3/_{12}$ der vorgegebenen Breite aufweisen.

2. Einzelgehäuse nach Anspruch 1, dadurch gekennzeichnet, dass jedes Gehäuseteil (12, 13) in seiner oberen und unteren Verbindungsfläche (14, 20) eine Nut (15) aufweist, in die ein Verbindungsstreifen (16) einbringbar ist.

3. Einzelgehäuse nach Anspruch 1 oder 2, dadurch gekennzeichnet, dass die Gehäuseteile (12, 13) Kunststoff-Spritzteile sind und dass der Verbindungsstreifen (16) aus einem verhältnismässig weichen Metall mit leichter Riffelung besteht.

4. Einzelgehäuse nach Anspruch 1 oder 2, dadurch gekennzeichnet, dass die Gehäuseteile Metall-Spritzteile sind und dass der Verbindungsstreifen aus Kunststoff besteht.

5. Einzelgehäuse nach einem der vorangehenden Ansprüche, dadurch gekennzeichnet, dass jedes Gehäuseteil (12, 13) an seiner Vorderseite einen sich jeweils bis zu den Verbindungsflächen (14, 20) erstreckenden Kragen (19, 21) aufweist und dass der Kragen (19, 21) an seinem einen Ende eine Ausnehmung (22) und an seinem anderen Ende einen Verbindungsansatz (23, 24) aufweist.

6. Einzelgehäuse nach einem der vorangehenden Ansprüche, dadurch gekennzeichnet, dass jedes Gehäuseteil (12, 13) an seiner Rückseite (11) eine Nut (27) zur Aufnahme einer Rückwand (28) aufweist, dass jedes Gehäuseteil (12, 13) an seiner Rückseite (11) einen Befestigungslappen (29) trägt und dass die Rückwand (28) mit dem Befestigungslappen (29) verbunden ist.

## Claims

1. Individual housing for a housing arrangement which may be constructed modularly and in which each of the individual housing is of such a width that by arranging a plurality of individual housings side by side, a predetermined width may be obtained in each case, characterised in that each individual housing (10) comprises two housing portions (12, 13) and in that the housing portions (12, 13) have, in each case, a width of either $^1/_{12}$ or $^3/_{12}$ of the predetermined width.

2. Individual housing according to claim 1, characterised in that each housing portion (12, 13) has in its upper and lower connecting area (14, 20) a groove (15) into which a connecting strip (16) may be introduced.

3. Individual housing according to claim 1 or 2, characterised in that the housing portions (12, 13) are synthetic moulded portions and in that the connecting strip (16) is made of a comparatively soft metal with slight corrugation.

4. Individual housing according to claim 1 or 2, characterised in that the housing portions are metal moulded portions and in that the connecting strip is made of synthetic material.

5. Individual housing according to one of the preceding claims, characterised in that each housing portion (12, 13) has, on its front side, a collar (19, 21) which extends in each case as far as the connecting areas (14, 20) and in that the collar (19, 21) has at its one end a recess (22) and at its other end a connecting attachment (23, 24).

6. Individual housing according to one of the preceding claims, characterised in that each housing portion (12, 13) has, on its rear side (11), a groove (27) for accommodating a rear wall (28), it that each housing portion (12, 13) bears, on its rear side (11), a fastening lug (29) and in that the rear wall (28) is connected with the fastening lug (29).

## Revendications

1. Boîtier élémentaire pour un système de boîtiers à construction modulaire, dont les différents boîtiers élémentaires possèdent une largeur telle que la juxtaposition de plusieurs boîtiers élémentaires permet chaque fois d'obtenir une largeur préfixée, caractérisé en ce que chaque boîtier élémentaire (10) est composé de deux parties (12, 13) possédant chacune une largeur correspondant à $^1/_{12}$ ou à $^3/_{12}$ de la largeur préfixée.

2. Boîtier selon la revendication 1, caractérisé en ce que chaque partie de boîtier (12, 13) présente dans sa face de jonction supérieure et sa face de jonction inférieure (14, 20) une rainure (15) dans laquelle peut être insérée une bande de jonction (16).

3. Boîtier selon la revendication 1 ou 2, caractérisé en ce que les parties de boîtier (12, 13) sont des pièces moulées par injection en matière plastique et que la bande de jonction (16) est faite d'un métal relativement tendre avec une légère striure.

4. Boîtier selon la revendication 1 ou 2, caractérisé en ce que les parties de boîtier sont des pièces moulées en métal et que la bande de jonction est en matière plastique.

5. Boîtier selon une des revendications précédentes, caractérisé en ce que chaque partie de boîtier (12, 13) présente sur son côté avant un rebord (19, 21) s'étendant jusqu'aux faces de jonction (14, 20) et que le rebord (19, 21) possède un évidement (22) à l'une de ses extrémités et une saillie d'assemblage (23, 24) à son autre extrémité.

6. Boîtier selon une des revendications précédentes, caractérisé en ce que chaque partie de boîtier (12, 13) présente sur son côté arrière (11) une rainure (27) pour la réception d'une paroi arrière (28), que chaque partie de boîtier (12, 13) porte sur son côté arrière (11) une patte de fixation (29) et que la paroi arrière (28) est reliée à la patte de fixation (29).

FIG.1

FIG.2